(19)

Europäisches
Patentamt
European
Patent Office
Office européen
des brevets

(11) **EP 2 477 469 A2**

(12) **EUROPEAN PATENT APPLICATION**

(43) Date of publication:
**18.07.2012 Bulletin 2012/29**

(51) Int Cl.:
**H05K 13/08** (2006.01)

(21) Application number: **11186672.9**

(22) Date of filing: **26.10.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **18.01.2011 JP 2011008267**

(71) Applicant: Omron Corporation
**Kyoto-shi, Kyoto 600-8530 (JP)**

(72) Inventors:
• **Mori, Hiroyuki**
  **Kyoto 600-8530 (JP)**
• **Nakajima, Katsuki**
  **Kyoto 600-8530 (JP)**
• **Tasaki, Hiroshi**
  **Kyoto 600-8530 (JP)**

(74) Representative: **Horn Kleimann Waitzhofer**
  **Elsenheimerstrasse 65**
  **80687 München (DE)**

(54) **Suitability determination method for determination standard value and method for specifying optimum value thereof, inspection system for substrate on which components are mounted, simulation method at production site, and simulation system**

(57)    The determination of the suitability of the determination standard value for an intermediate inspection and a process for specifying the optimum value of the determination standard value are accurately performed even if the number of actual measured values indicating a defect is small. A correlation between the measured values X for which the intermediate inspection is to be performed and the measured values Y for which the final inspection is to be performed is derived. Thereafter, for each of a plurality of calculation target points set on the X-axis, the distribution pattern of the measured values Y for the measured value Xn indicated by that point is specified based on the correlation, and the probabilities of the range $W_{OK}$ that is determined to be non-defective with the determination standard value Ys of the final inspection and the range $W_{NG}$ that is determined to be defective that are included in the distribution are calculated. Further, for each of the ranges of the measured values X that are respectively determined to be defective and non-defective with the determination standard value Xs of the intermediate inspection, the degree of consistency and the degree of inconsistency between the results of the inspections are determined using the probabilities determined for the calculation target points included in that range, and the suitability of the determination standard value Xs is determined based on the two degrees.

**FIG. 6**

EP 2 477 469 A2

**Description**

TECHNICAL FIELD

The present invention relates to a method for determining whether a determination standard value used for an inspection of an intermediate product is suitable, assuming that a final inspection of a final-form product that is formed through a plurality of steps and an intermediate inspection of an intermediate product that is formed in a step prior to the final step are performed. The present invention also relates to a method for determining an optimum value for the determination standard value used for the inspection of the intermediate product and an inspection system for a substrate on which components are mounted to which the method has been applied, and a computer system that performs a simulation showing how the productivity of substrates on which components are mounted changes depending on the determination standard value.

RELATED ART

In general, a substrate on which components are mounted is produced by a cream solder printing step, a component mount step, and a reflow step. Recent production lines include a line provided with a substrate inspection system in which an inspection machine for each of these steps and the inspection results obtained by the inspection machines can be accumulated in an information processing device and confirmed by being checked for the same object (see, for example, Patent Document 1).

With a conventional substrate inspection system, each of the inspection machines performs a measurement for a portion to be inspected based on an inspection program that is set for the machine, and determines whether the portion is defective or not by comparing the obtained measured value with a registered determination standard value. For this reason, there is the possibility that a location that has been determined to be defective in the inspection machine for the solder print step or the component mount step may be determined to be non-defective in the final inspection performed by the inspection machine for the final reflow step, or vice versa.

If the frequency of inconsistency between the result of the intermediate inspection and the result of the final inspection increases, then the merit obtained by performing the intermediate inspection is reduced, and there will be no meaning to the costs for the inspections. In particular, there will be a significant loss in terms of not only costs but also the processing time if the frequency with which a product that is determined to be non-defective in the final inspection is determined to be defective in the intermediate inspection increases when a substrate for which a defect has been detected in the intermediate inspection is removed or when the line is stopped for checking.

In contrast, if the frequency with which the result of the intermediate inspection and the result of the final inspection are consistent is increased, then a product that may become defective can be accurately determined in the intermediate inspection, thus making it possible to increase the production efficiency. Accordingly, it is desirable to adjust the determination standard value used for the intermediate inspection such that the consistency between the results of the two inspections can be increased as much as possible.

With regard to the above-described problem, Patent Documents 2 and 3 describe that a suitable determination standard value is defined through a calculation process based on measured values obtained in the intermediate inspection and the relationship between the results of the intermediate inspection and the final inspection.

First, Patent Document 2 describes that while changing, in several stages, the determination standard value (called "inspection standard" in Patent Document 2) for the characteristic amount extracted in the intermediate inspection; the yield rate and the over detection rate obtained when the inspection is performed with the determination standard value are determined; the yield rate and the defect rate in the final inspection are determined; the reinspection cost is further determined from these values; and the value of the determination standard value when the reinspection cost is the smallest is used as a recommended value (see, for example, paragraphs 0067 to 0068 of Patent Document 2).

Further, Patent Document 2 describes that in order to select an inspection item suitable for resetting the above-described determination standard value, the distribution of the characteristic amounts determined by the measurement process is analyzed for each of a plurality of inspection items in the intermediate inspection; the degree of separation between the group determined to be non-defective and the group determined to be defective in the final inspection is determined; and an inspection item for which the degree of separation is the largest is selected as a candidate for resetting (see, for example, paragraphs 0057 to 0066 of Patent Document 2).

Patent Document 3 describes that for a plurality of substrates that have portions for which a common determination standard value is used and that provide the same determination result (non-defective or defective) in the final inspection, the process for calculating the number of substrates for which a determination different from that in the final inspection has been made in the measurement process in the intermediate inspection is repeatedly executed, while changing the determination standard value, and the standard value when the calculated number of the substrates represents the ratio corresponding to the pre-set allowable value for the occurrence frequency of determination inconsistency is selected as the optimum value.

RELATED ART DOCUMENTS

PATENT DOCUMENTS

[Patent Document 1] Japanese Patent No. 3966336
[Patent Document 2] Japanese Patent No. 4552749
[Patent Document 3] Japanese Published Patent Application No. 2008-10666

SUMMARY OF THE INVENTION

PROBLEMS TO BE SOLVED BY THE INVENTION

In the inventions described in Patent Documents 2 and 3, measured values determined by an actual measurement process are analyzed based on the relationship with the result of each of the inspections, and therefore it is necessary to prepare measured values that are determined to be non-defective with a suitable determination standard value and a significant number of measured values that are determined to be defective with that determination standard value in order to obtain a highly reliable result. However, not so many actual defects occur, and therefore it is difficult to collect a sufficient number of defective samples.

With the focus in this point, it is an object of the present invention to accurately determine whether a determination standard value for the intermediate inspection is suitable by a calculation based on a correlation between the measured values for an intermediate product and the measured values for a final-form product that is formed from the intermediate product even if the number of actual measured values indicating a defect is small. It is also an object of the present invention to specify, by the same calculation process, a numeric value with which the consistency between the determination standard value used for the intermediate inspection and the result of the final inspection can be sufficiently ensured.

MEANS FOR SOLVING THE PROBLEMS

A suitability determination method for a determination standard value according to the present invention determines, based on a relationship between a final inspection of inspecting a final-form product formed through a plurality of steps and an intermediate inspection of inspecting an intermediate product formed in a step before the final step, whether a determination standard value used for the intermediate inspection is suitable, and executes the process including the following first to fifth steps.

In the first step, for each of a plurality of intermediate products and final-form products formed from the intermediate products, a measurement process for obtaining a characteristic amount to be inspected is executed, and a plurality of samples by forming combinations of the measured values is set, with each of the combinations corresponding to the same product. In the second step, a correlation between the measured values for the intermediate products and the measured values for the final-form products are derived by using the combinations of the measured values indicated by the plurality of samples.

In the third step, a first calculation process for setting a plurality of calculation target points in a range in which the measured values for the intermediate products can be distributed and specifying a distribution pattern of the measured values of the final-form products that corresponds to the measured values indicated by the calculation target points based on the correlation derived in the second step, and a second calculation process for determining, based on the relationship between the distribution pattern and the determination standard value used for the final inspection, at least one of a probability that the final-form products formed from the intermediate products for which the measured values indicated by the calculation target points are obtained are determined to be non-defective in the final inspection and a probability that the aforementioned final-form products are determined to be defective in the final inspection are executed for each of the calculation target points.

Note that the range in which the calculation target points are set may be the same range as the distribution range of the samples, but may be a wider range. The setting interval for the calculation target points may not be dependent on the density of the samples, and may be set to an interval required to ensure the precision of a later process.

In the fourth step, the range in which the calculation target points are set is divided into a range that is determined to be non-defective and a range that is determined to be defective based on the determination standard value used for the intermediate inspection, and, for each of the aforementioned ranges, the degree of consistency between a result of the intermediate inspection and a result of the final inspection and the degree of inconsistency between the aforementioned inspection results by using the probability calculated by the second calculation process for the calculation target points included in the range are determined.

In the fifth step, whether the determination standard value used for the intermediate inspection is suitable is determined based on the degree of consistency and the degree of inconsistency in each of the ranges that have been determined in the fourth step. For example, the suitability of the determination standard value can be determined from the degree of separation between the numeric value range that is determined to be non-defective and the numeric value range that is determined to be defective with the determination standard value.

Alternatively, at a site where an importance is placed on the productivity, in the fifth step, the proportion of intermediate products that pass the intermediate inspection in a predetermined number of intermediate products (yield rate) may be calculated, and the suitability of the determination standard value may be determined based on whether the calculated value indicates a value greater than or equal to the standard required by the user.

According to the above-described method, after a correlation between the actually obtained measured values for the intermediate products and the final-form products has been determined, the degree of consistency between the intermediate inspection result and the final inspection result and the degree of inconsistency therebetween are determined without relying on these actual measured values. Accordingly, even if the number of samples including actual measured values, in particular, measured values indicating a defect, is not sufficient, it is possible to accurately determine the degree of consistency and the degree of inconsistency between the inspection results. This enables precision to be ensured also for the suitability of the determination standard value.

In a preferred embodiment of the above-described method, in the second step, a regression line between the measured values for the intermediate products and the measured values for the final-form products is derived. In the first calculation process of the third step, a mean value of the measured values of the final-form products is determined by applying the measured values corresponding to the calculation target points to the formula of the regression line, and a variation in the measured values of the final-form products is calculated by correcting the standard error of the regression line using a correction function that functions to decrease the value of the standard error with an increase in the difference between a mean value of the measured values for the intermediate products that are indicated by the plurality of samples and the measured values indicated by the calculation target points.

When a regression line between the measured values for the intermediate product and the measured values for the final-form product is determined, the variation in the latter measured values for each measured value of the former can be generally determined from the standard error of the regression line. However, in view of the actual circumstances at production sites, it seems that the variation in the measured values for the final-form product decreases as the measured values of the corresponding intermediate product deviate from their mean value. According to the above-described embodiment, the standard error of the regression line can be corrected according to this characteristic of the distribution, and therefore it is possible to accurately determine the variation in the measured values of the final-form product corresponding to each calculation target point.

In another preferred embodiment of the above-described method, in the fourth step, for each of the divided ranges, a mean value of the probabilities that have been calculated by the second calculation process for the calculation target points included in the range is calculated, and, based on a result of the calculation, for each combination of a result of the intermediate inspection and a result of the final inspection, the occurrence probability of that combination is calculated. Accordingly, the occurrence probability is calculated for each of the group that is determined to be non-defective in both of the inspections, the group that is determined to be defective in both of the inspections, the group that is determined to be non-defective in the intermediate inspection and is determined to be defective in the final inspection, and the group that is determined to be defective in the intermediate inspection and is determined to be non-defective in the final inspection, and therefore it is possible to easily execute the determination process in the fifth step.

Next, in a method for specifying an optimum value of a determination standard value according to the present invention, after the same first to third steps as described above are executed, a process for dividing, while varying the determination standard value used for the intermediate inspection, the range in which the calculation target points are set into a range that is determined to be non-defective and a range that is determined to be defective based on the determination standard value, and determining, for each of the aforementioned ranges, the degree of consistency between a result of the intermediate inspection and a result of the final inspection and the degree of inconsistency between the aforementioned inspection results by using the probability calculated by the second calculation process for the calculation target points included in the range is executed as a fourth step for each of the varied determination standard values. Also, a fifth step of selecting, in response to determining the degree of consistency and the degree of inconsistency for each of the determination standard values in the fourth step, a suitable value from the determination standard values based on the aforementioned degrees is executed.

According to the above-described method, even if the initial determination standard value set for the intermediate inspection is not suitable, performing the above-described method at the stage in which a certain number of measured values have been accumulated by the inspection enables the suitable value of the determination standard value to be specified, thus rewriting the determination standard value to that value. Further, this method can also be performed when deciding the determination standard value for intermediate inspection before the inspection.

An inspection system for a substrate on which components are mounted according to the present invention includes an inspection machine for final inspection that is provided in a reflow step included in a plurality of steps for producing a substrate on which components are mounted, and an inspection machine for intermediate inspection that is provided in at least one step located before the reflow step.
The inspection system further includes a computer system including: a storage means that stores results of a measurement process performed by the inspection machines and inspection results in a state in which the identity of a portion to be inspected can be specified; and a determination standard value processing means that analyses information stored in the storage means for a plurality of portions to be inspected to which the same determination standard value can be applied and executes a process relating to the determination standard value used for the intermediate inspection of the portions to be inspected.

In a first inspection system, the determination standard value specifying means includes a sample setting means, a correlation derivation means, a first analysis means, a second analysis means, a determination means, and an output means described below.

The sample setting means sets a plurality of samples by forming combinations of the measured values in the intermediate inspection and the measured values in the final inspection of the plurality of portions to be inspected, each of the combinations corresponding to the same portion. The correlation derivation means derives a correlation between the measured values in the intermediate inspection and the measured values in the final inspection by using the combinations of the measured values indicated by the plurality of samples.

The first analysis means executes a first calculation process for setting a plurality of calculation target points in a range in which the measured values in the intermediate inspection can be distributed and specifying a distribution pattern of the measured values in the final inspection that corresponds to the measured values indicated by the calculation target points based on the correlation derived by the correlation derivation means, and a second calculation process for determining, based on the relationship between the distribution pattern and the determination standard value used for the final inspection, at least one of a probability that the portions to be inspected for which the measured values indicated by the calculation target points are obtained are determined to be non-defective in the final inspection and a probability that the aforementioned portions to be inspected are determined to be defective in the final inspection, the third step being executed for each of the calculation target points.

The second analysis means divides the range in which the calculation target points are set into a range that is determined to be non-defective and a range that is determined to be defective based on the determination standard value used for the intermediate inspection, and determining, for each of the aforementioned ranges, the degree of consistency between a result of the intermediate inspection and a result of the final inspection and the degree of inconsistency between the aforementioned inspection results by using the probability calculated by the second calculation process for the calculation target points included in the range.

The determination means determines whether the determination standard value used for the intermediate inspection is suitable based on the degree of consistency and the degree of inconsistency in each of the ranges that have been determined by the second analysis means. The output means outputs a result of determination performed by the determination means.

With the above-described system, the suitability of a determination standard value for the intermediate inspection in the production of substrates on which components are mounted can be accurately determined.

The determination standard value processing means of a second inspection system according to the present invention includes a sample setting means, a correlation derivation means, a first analysis means, a second analysis means, a determination standard value selection means, and an output means.

The configurations of the sample setting means, the correlation derivation means, and the first analysis means are the same as those of the first system. The second analysis means executes the same process as that performed by the second analysis means of the first system for each of the varied determination standard values. The determination standard value selection means selects, in response to determining the degree of consistency and the degree of inconsistency for each of the determination standard values by the second analysis means, a suitable value from the determination standard values based on the aforementioned degrees, and the output means outputs the determination standard value selected by the determination standard value selection means.

With the inspection system having the above-described configuration, it is possible to accurately specify a determination standard value that is suitable for the intermediate inspection in the production of substrates on which components are mounted.

In a preferred embodiment of the second inspection system, the output means is configured as a means that transmits, to the inspection machine for intermediate inspection, the determination standard value selected by the standard value selection means. Also, the inspection machine for intermediate inspection is provided with a means that registers the determination standard value transmitted from the output means for intermediate inspection.

According to the above-described embodiment, as a result of selection of a suitable determination standard value by the process executed by the computer system, the selected determination standard value can be used for a subsequent intermediate inspection.

The present invention is also applicable to a simulation method for performing, using a computer, a simulation calculation for deriving, in a production line in which a final inspection of inspecting a final-form product formed through a plurality of steps and an intermediate inspection of inspecting an intermediate product formed in a step before the final step are performed, a result for each of the inspections. With this method, the first step, the second step, and the third step that are the same as those of the above-described suitability determination method for a determination standard value are performed. However, in the second calculation process in the third step, both a probability that the final-form products formed from the intermediate products for which the measured values indicated by the calculation target points are obtained are determined to be non-defective in the final inspection and a probability that the aforementioned final-form products are determined to be defective in the final inspection are determined.

Further, in this simulation method, the following fourth, fifth, and sixth steps are performed.

In the fourth step, an input of a set value is accepted as the determination standard value used for the intermediate inspection, the range in which the calculation target points are set is divided into a range that is determined to be non-defective and a range that is determined to be defective based on the input value, and a probability that the intermediate products are determined to be defective is determined by using the two probabilities calculated by the second calculation process for the calculation target points included in the range that is determined to be defective, while determining a probability that a final product formed from an intermediate product that has passed the intermediate inspection is determined to be non-defective and a probability that the aforementioned final product is determined to be defective by processing each of the two probabilities calculated by the second calculation process for the calculation target points included in the range that is determined to be non-defective.

In the fifth step, using the probabilities calculated in the fourth step, the proportion of intermediate products that pass or fail the intermediate inspection in a predetermined number of intermediate products produced in a production line and the proportion of intermediate products that pass or fail the final inspection in intermediate products that have passed the intermediate inspection are determined. In the sixth step, the proportions calculated in the fifth step are displayed as results of the simulation calculation.

With the above-described simulation method, if the user performs the intermediate inspection using a value that the user has input as the determination standard value for the intermediate inspection, the information indicating an approximate proportion of occurrence of intermediate products that pass or fail the intermediate inspection and an approximate proportion of occurrence of final-form products that eventually become non-defective products in the final-form products formed from the intermediate products that have passed the intermediate inspection can be determined by the simulation calculation and then be displayed. The user can judge whether the input set value is suitable as the determination standard value by checking whether the displayed information provides results that match the production efficiency or cost target.

The above-described simulation method is applicable to a simulation system for a substrate production line including a plurality of steps for producing a substrate on which components are mounted and in which an inspection machine for intermediate inspection is provided in a reflow step included in the aforementioned steps and inspection machine for final inspection is provided in at least one step located before the reflow step. This system includes a storage means that stores measured values obtained by a measurement process executed by the inspection machines for obtaining a characteristic amount to be inspected in a state in which the identity of a portion to be inspected can be specified and stores the determination standard value used for the final inspection; an input means that accepts an input of a set value of the determination standard value used for the intermediate inspection of a plurality of portions to be inspected to which the same determination standard value can be applied; a simulation calculation means that analyses information stored in the storage means for the portions to be inspected to which the input determination standard value is applied and executes a simulation calculation for the portions to be inspected; and a display means that displays results of the simulation calculation.

The simulation calculation means includes a sample setting means that sets a plurality of samples by forming combinations of the measured values obtained from by the inspection machines for the portions to be inspected that are subject to calculation, each of the combinations corresponding to the same portion; a correlation derivation means that derives a correlation between the measured values in the intermediate inspection and the measured values in the final inspection by using the combinations of the measured values indicated by the plurality of samples; a first analysis means that executes a first calculation process for setting a plurality of calculation target points in a range in which the measured values obtained by the measurement process for the intermediate inspection can be distributed and specifying a distribution pattern of the measured values in the final inspection that corresponds to the measured values indicated by the calculation target points based on the correlation derived by the correlation derivation means, and a second calculation process for determining, based on the relationship between the distribution pattern and the determination standard value for the final inspection that is stored in the storage means, a probability that the portions to be inspected for which the measured values indicated by the calculation target points are obtained are determined to be non-defective in the final inspection and a probability that the aforementioned portions to be inspected are determined to be defective in the final inspection, the third step being executed for each of the calculation target points; a second analysis means divides the range in which the calculation target points are set into a range that is determined to be non-defective and a range that is determined to be defective based on the set value of the determination standard value accepted by the input means, and determines a probability that the portions to be inspected are determined to be defective in the intermediate inspection of the calculation target points included in the range that is determined to be defective by using the two probabilities calculated by the second calculation process, while determining a probability that portions that have passed the intermediate inspection are determined to be non-defective in the final inspection and a probability that the aforementioned portions are determined to be defective in the final inspection by processing each of the two probabilities calculated in the second calculation process for the calculation target points included in the range that is to be non-defective; and a third analysis means that determines, using the probabilities calculated by the second analysis means, the proportion of substrates that pass or fail the intermediate inspection in substrates introduced into a step in which the inspection machine for intermediate inspection is provided and the proportion of substrates that pass or fail the final inspection in substrates that have passed the intermediate inspection.

The display means displays the proportions calculated by the third analysis means as results of the simulation calculation.

## EFFECTS OF THE INVENTION

According to the present invention, even if a sufficient number of samples of measured values indicating a defect cannot be obtained, it is possible to accurately execute, for example, the process for determining the suitability of a determination standard value used for the intermediate inspection, the process for specifying a suitable determination standard value, and the process for simulating results of the inspections using a set value that is input as the determination standard value for the intermediate inspection.

## BRIEF DESCRIPTION OF THE DRAWINGS

Fig. 1  is a block diagram showing the configuration of a substrate inspection system in correspondence with the configuration of a production line of a substrate on which components are mounted.

Fig. 2  shows a method for obtaining samples of measured values.

Fig. 3  is a graph showing the relationship in a distribution of measured values.

Fig. 4  is a flowchart schematically illustrating the procedure of a process for determining the suitability of a determination standard value for an intermediate inspection.

Fig. 5  is a graph showing an example of the relationship between the measured values X and a distribution pattern of the measured values Y.

Fig. 6  is a graph showing a distribution of the measured values Y corresponding to a given measured value Xn, separately for a range that is determined to be non-defective and a range that is determined to be defective

Fig. 7  is a flowchart schematically illustrating the procedure of a process for specifying an optimum value for a determination standard value for the intermediate inspection.

Fig. 8  shows an example of a display screen showing a result of specifying the optimum value for a determination standard value

Fig. 9  is a flowchart illustrating the procedure of a simulation process that is executed in response to an input of a determination standard value for the intermediate inspection.

## EMBODIMENTS OF THE INVENTION

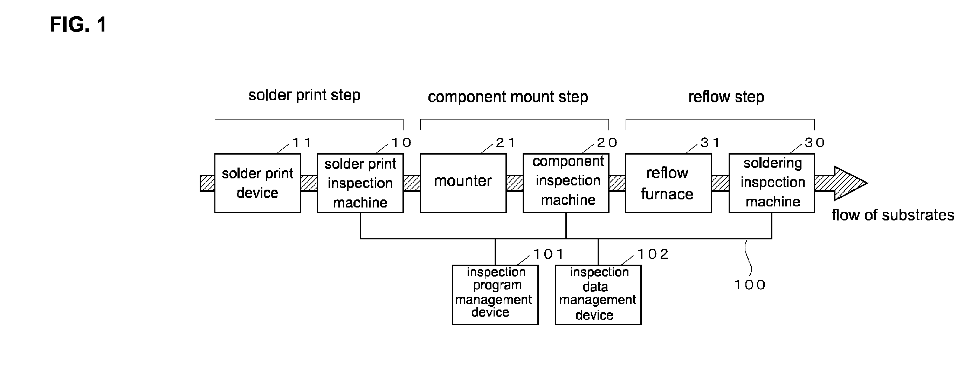

Fig. 1 shows the configuration of a substrate inspection system according to one embodiment in correspondence with the overall configuration of a production line of a substrate on which components are mounted.

The production line shown in the drawing includes a solder print step, a component mount step, and a reflow step. In the solder print step, a solder print device 11 that applies a cream solder to lands on a substrate and a solder print inspection machine 10 that inspects results of the process performed by the device 11 are provided. In the component mount step, a mounter 21 that mounts one or more components to a substrate that has been subjected to solder printing and a component inspection machine 20 that inspects the mount state of the component are provided. In the reflow step, a reflow furnace 31 that melts the cream solder of a substrate to which a component has been mounted and a soldering inspection machine 30 that inspects a substrate that has been subjected to reflow are provided. As indicated by the thick arrow in the drawing, a substrate on which components are mounted in conformity with a predetermined standard is completed by processing a substrate by feeding it into the devices in order.

The inspection machines 10, 20, and 30 are connected to each other via a LAN line 100. An inspection program management device 101 and an inspection data management device 102 are also connected to the LAN line 100.

The solder print inspection machine 10 of this embodiment has a three-dimensional measurement function, and uses this function to measure the height and the volume of the cream solder applied to lands of a substrate as well as to measure the position and the area of the print range of the cream solder. Then, for each of the measured values, the solder print inspection machine 10 compares the measured value with a determination standard value registered in advance and determines the non-defectiveness or defectiveness of that measured value.

The component inspection machine 20 detects an image of a component through two-dimensional image processing and determines, for example, the presence or absence of a component or the presence or absence of a mount error based on a result of the detection. The component inspection machine 20 further measures the positional displacement or the rotational displacement of the component, compares the measured value with the determination standard value that has been registered in advance, and determines the non-defectiveness or defectiveness of the measured value.

The soldering inspection machine 30 includes, for example, an illumination device that applies a plurality of color light beams from directions with respective different angles of incidence and a color camera. Imaging of a substrate to be inspected under illumination from the illumination device generates an image that represents the sloping state of a soldered portion of the substrate by the distribution pattern of colors corresponding to the respective illumination light beams. The soldering inspection machine 30 uses this image to measure the position and the area of each component for each electrode and the height to which the fillets have been wetted (hereinafter, simply referred to as "fillet height"). Then, for each of the measured values, the soldering inspection machine 30 compares the measured value with the determination standard value that has been registered in advance, thereby determining the non-defectiveness or defectiveness of that measured value.

Note that this embodiment utilizes the fact that approximate angles of inclination of the solder corresponding to the colors contained in the image can be identified from the angles of incidence of the colored light beams, and specifies a curve that approximates the shape of the solder fillet from the distribution of the colors contained in the image, as the measurement process for specifying the fillet height. Then, this curve is integrated and the obtained integral value is used as the fillet height.

Further, each of the inspection machines 10, 20, and 30 collectively determines the non-defectiveness or defectiveness of the determination results for the measured values for each component or each range corresponding to a component, and thereafter makes a determination of the non-defectiveness or defectiveness for each substrate. Then, each of the inspection machines 10, 20, and 30 creates inspection result information containing each determination result and each measurement result, and outputs the information to the inspection data management device 102 via the LAN line 100.

A database in which inspection programs are collected as library data for each component type is registered in the inspection program management device 101 for each of the inspection machines 10, 20, and 30. The inspection programs have been created based on a preset inspection standard, and include programs for executing the above-described various measurement processes. Also, the determination standard values are defined in the inspection programs.

Prior to inspection, data (for example, CAD data) indicating the configuration of a substrate to be inspected is input into the inspection machines 10, 20, and 30. The inspection machines 10, 20, and 30 fetch the library data suitable for the component type information of each component indicated in the input data from the inspection program management device 101 and execute a process for associating the positional information of each component with the library data. Thereby, an environment necessary for inspection of the substrate to be inspected is set in each of the inspection machines 10, 20, and 30.

The inspection result information that has been output from each of the inspection machines 10, 20, and 30 is stored in the inspection data management device 102. The inspection result information is configured to be read for each of the inspection machines 10, 20, and 30, and also to be read for each substrate and for each component on the substrate. Furthermore, with regard to the solder print inspection machine 10 and the soldering inspection machine 30, the measurement result and determination result can be read for each electrode of the component.

Note that the inspection program management device 101 and the inspection data management device 102 do not necessarily have to be separate, and it is possible to provide a single computer with the functions of the management devices 101 and 102. Conversely, each of the management devices 101 and 102 may be configured by a plurality of computers. Also, it is possible to add a terminal device in the system in order to operate each of the management devices 101 and 102 and to display the results of the processes.

Furthermore, the inspection program management device 101 of this embodiment is provided with the function of checking whether the determination standard value that has been applied to the inspection machines 10 and 20 in a step before the reflow step is suitable and the function of correcting any unsuitable determination standard value to an optimum value. These functions are aimed at increasing the degree of consistency between the results of the intermediate inspection performed by the inspection machines 10 and 20 and the results of the final inspection performed by the soldering inspection machine 30, and are performed for each component type or for a selected specific component type. Note that inspection with a plurality of inspection items is performed in each of the intermediate inspection and the final inspection, and the above-described determination process for the determination standard in the intermediate inspection is executed for a combination of inspection items for which measured values are confirmed to have a high correlation between the intermediate inspection and the final inspection.

In the following, the outline of the process executed by the inspection program management device 101 will be described assuming, as a specific example, a case where the solder volume inspection performed by the solder print inspection machine 10 and the fillet height inspection performed by the soldering inspection machine 30 are selected and the suitability of the determination standard value used for the former inspection is determined.

First, in order to determine the suitability of the determination standard value in the intermediate inspection, the inspection program management device 101 obtains, from the inspection data management device 102, a plurality of measured values (the volume of the cream solder and the height of the fillet) that have been obtained by the inspection machines 10 and 30 by the measurement process for a component to be processed, and sets samples in each of which the measured values corresponding to the same portion of the same component are combined.

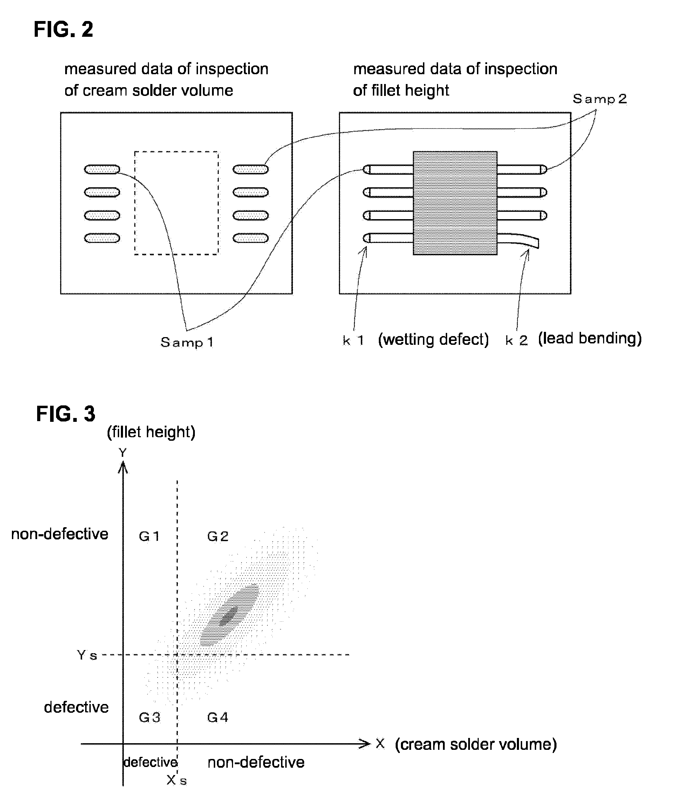

Fig. 2 shows a method for obtaining samples of measured values from inspection results for lead components. In this example, all measured values corresponding to individual electrodes of the lead components to be processed are read from sets of the measured values for the cream solder volume in a substrate that has been subjected to solder printing. All measured values for each electrode of components of the component type to be processed are read in the same manner also for the measured values for the fillet height in a substrate that has been subjected to reflow. Then, as shown by Samp1 and Samp2 in the drawing, the measured values corresponding to the same electrode of the same component are combined. With this method, a number of samples corresponding to the number of the electrodes can be set from the inspection results for a single component.

By further executing the same process for a plurality of components of the same type, it is possible to obtain a considerable number of samples. However, if different determination standard values are applied depending on the position of the electrode, it is necessary to limit the acquisition of samples to the electrodes to which the determination standard value of interest is applied.

To increase the precision of the correlation between the two types of measured values indicated by the samples, it is desirable to exclude, from the samples, measured values of portions for which a defect has been detected for an inspection item other than the inspection item of interest. For example, in the example shown in Fig. 2, assuming that a solder wetting defect has been detected at the location indicated by the arrow K1 and an electrode bending defect has been detected at the location indicated by the arrow K2, it is desirable that a combination of measured values of the cream solder volume and the fillet height for these locations is excluded from the samples.

Fig. 3 is an exemplary graph showing the distribution state of the samples.
On this graph, samples are plotted with the cream solder volume set on the X-axis (horizontal axis) and the fillet height set on the Y-axis (vertical axis). Further, Xs on the X-axis is the determination standard value used for the cream solder volume inspection and Ys on the Y-axis is the determination standard value used for the fillet height inspection. Note that the value of the determination standard value Xs can be changed, but the value of the determination standard value Ys is fixed to a specific value based on the actual favorable fillet height.

Here, based on the determination standard values Xs and Ys, the combinations of measured values are classified into the following four groups: G1, G2, G3, and G4. Note that in the following, the final inspection is the fillet height inspection and the intermediate inspection is the cream solder volume inspection.

G1: Determined to be defective in the intermediate inspection, but determined to be non-defective in the final inspection
G2: Determined to be non-defective in both the intermediate inspection and the final inspection
G3: Determined to be defective in both the intermediate inspection and the final inspection
G4: Determined to be non-defective in the intermediate inspection, but determined to be defective in the final inspection

In the following, the occurrence probabilities of the groups G1, G2, G3, G4 are referred to as P1, P2, P3, and P4, respectively.
For the determination standard value Xs in the intermediate inspection to be suitable, Xs needs to be set at a position where the degree of consistency between the result of the intermediate inspection and the result of the final inspection (indicated by the probability P2 of the group G2 and the probability P3 of the group G3) is sufficiently large and the degree of inconsistency between the two inspection results (indicated by the probability P1 of the group G1 and the probability P4 of the group G4) is as small as possible.

Therefore, in this embodiment, with the use of the probabilities P1 to P4, the degree of separation S between these two groups of measured values are determined by using the following formula (1) when the measured values X in the intermediate inspection are divided according to the determination standard value Xs into a non-defective group and a defective group.

$$S = 10 \cdot \log_{10}\left[\frac{P_B \times P_C}{P_A \times P_D}\right] \quad \cdots (1)$$

where

$$P_A = \frac{P1}{P1+P2} \qquad P_B = \frac{P2}{P1+P2}$$

$$P_C = \frac{P3}{P3+P4} \qquad P_D = \frac{P4}{P3+P4}$$

In the formula (1), $P_B$ and $P_C$ represent the proportion of samples for which the intermediate inspection result and the final inspection result are consistent, and $P_A$ and $P_D$ represent the proportion of samples for which the inspection results are inconsistent. Therefore, according to the formula (1), the higher the proportion of samples included in the group G2 or G3 or the smaller the proportion of samples included in the group G1 or G4, the higher the value of the degree of separation S. Therefore, it can be considered that the higher the value of the degree of separation S, the more suitable the determination standard value Xs.

However, to ensure the determination precision, the values of the probabilities P1 to P4 used for calculation of the degree of separation S need to be accurately determined. According to the graph in Fig. 3, it can be understood that the cream solder volume and the fillet height are in such a relationship that the greater the value of the former, the greater the value of the latter. However, the samples that are extracted from the results of the measurement process for substrates produced in an actual production line generally have a favorable value, and it is difficult to obtain a sufficient number of samples indicating a defect. Therefore, if actual measured values are classified into the groups G1 to G4 based on the determination standard values Xs and Ys, then there is the possibility that although a sufficient number of samples may be obtained for the group G2, the number of samples that is required to ensure the precision of the probabilities P1, P3, and P4 may not be obtained for the other groups G1, G3, and G4.

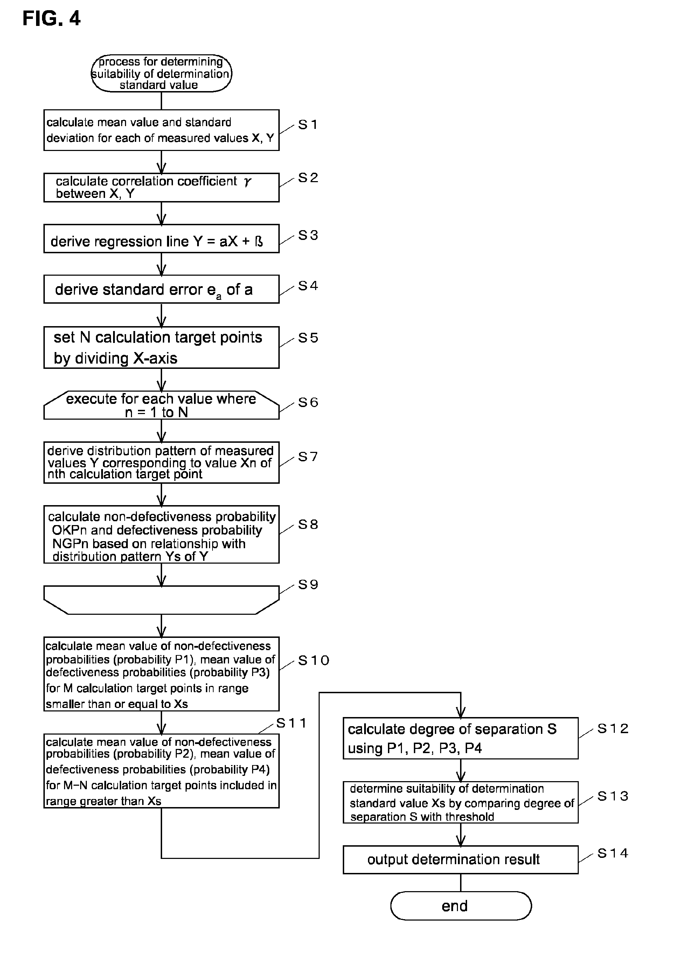

In view of this problem, in this embodiment, all the probabilities P1 to P4 of the groups G1 to G4 are accurately calculated by a calculation process that uses the correlation between the measured values X and Y indicated by the samples, thus ensuring the precision of determination of the suitability of the determination standard value Xs. The outline of this process will be described below with reference to Fig. 4.

In the process illustrated in Fig. 4, assuming that the measured values X and Y are both normally distributed, the mean value and the standard deviation of each sample is calculated for each of the measured values X and Y (step S1). In the following, the value of the measured values X and Y of a given sample are $X_k$ and $Y_k$, the mean value and the standard deviation of $X_k$ are Xa and $\sigma_x$, respectively, and the mean value and the standard deviation of $Y_k$ are Ya and $\sigma_y$, respectively.

Next, with the use of the measured values $X_k$ and $Y_k$ indicated by each sample and their mean values Xa and Ya, the correlation coefficient $\gamma$ between the measured values X and Y is determined by using the following formula (2) (step S2).

$$\gamma = \frac{\sum(X_k - Xa)(Y_k - Ya)}{\sqrt{\sum(X_k - Xa)^2}\sqrt{\sum(Y_k - Ya)^2}} \quad \cdots (2)$$

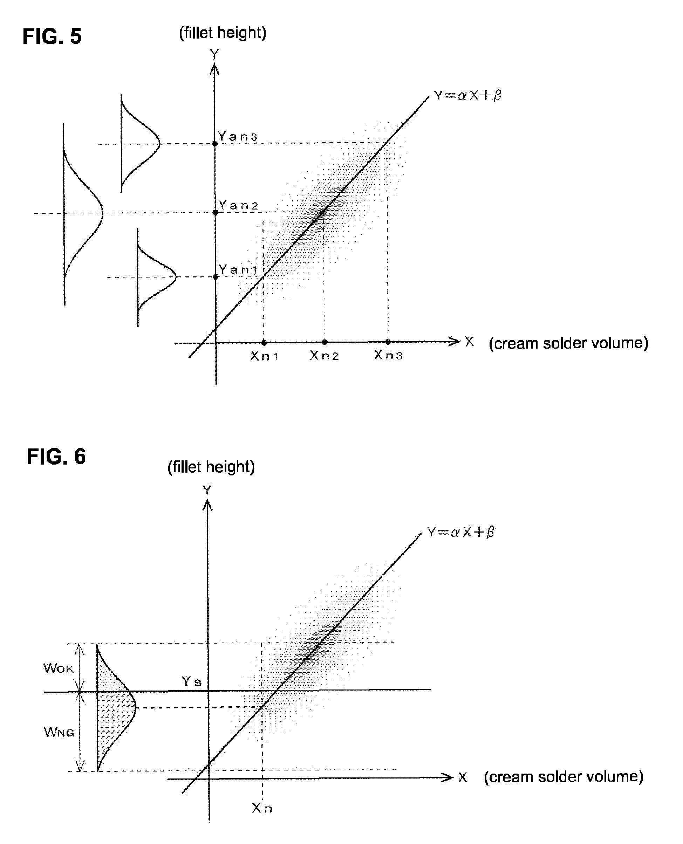

Further, with the use of the correlation coefficient $\gamma$, the standard deviations $\sigma_x$ and $\sigma_y$, and the mean values Xa and Ya, the regression line Y = $\alpha$X + $\beta$ (see Fig. 5) representing the relationship between X and Y is derived by executing the following formulas (3) and (4) (step S3).

$$\alpha = \gamma \times (\sigma Y / \sigma X) \quad \cdots \quad (3)$$

$$\beta = Ya - \alpha \times Xa \quad \cdots \quad (4)$$

Further, in step S4, with the use of the formula (5), the standard error $e_\alpha$ of the regression coefficient of the above regression line is derived.

$$e_\alpha = \frac{\sqrt{\sum e_k{}^2 / (k-2)}}{\sqrt{\sum (X_k - Xa)^2}} \quad \cdots \quad (5)$$

where

$$e_k = \alpha X_k + \beta - Y_k$$

In the following, based on the correlation between X and Y determined in steps S1 to S4 above, calculations for virtual measured values distributed in an XY plane, not for actual samples, are executed. First, N calculation target points are set by dividing the X-axis of the XY plane at a fixed interval (step S5), and the loop of S6 to S9 is executed while moving a counter from 1 to N. The core of this loop is made up of the process for deriving the distribution pattern of the measured values Y corresponding to the value Xn of the nth calculation target point (step S7) and the process for calculating, based on the relationship between the derived distribution pattern and the determination standard value Ys in the final inspection, the probability that the fillet height formed when the cream solder volume is Xn is determined to be non-defective (hereinafter, referred to as "non-defectiveness probability") OKPn and the probability that the above-described fillet height is determined to be defective (hereinafter, referred to as "defectiveness probability") NGPn (step S8).
Here, the calculations executed in steps S7 and S8 will be described in detail with reference to Figs. 5 and 6.
In Fig. 5, the regression line derived in step S3 is associated with a graph similar to that in Fig. 2. The distribution curves of the measured values Y respectively corresponding to given three points $Xn_1$, $Xn_2$, and $Xn_3$ on the X-axis are also shown. As shown in these distribution curves, the measured values Y respectively corresponding to the values of $Xn_1$, $Xn_2$, and $Xn_3$ are distributed in predetermined ranges including the distribution range of actual measured values of Y, with the predetermined ranges being respectively centered on the mean values $Yan_1$, $Yan_2$, and $Yan_3$, which can be calculated from the corresponding values of X and the regression line. However, the width of the distributions is not constant, and is considered to decrease with an increase in the distance of Xn from the center (mean value Xa) of distribution of X.
In step S7, in view of the above-described distribution characteristics, the mean value Yan of Y and the variance Vn when X = Xn are calculated.
First, from the regression line, the mean value Yan is:

$$Yan = \alpha Xn + \beta$$

The variance Vn is calculated by using the following formula (6). Note that in the formula (6), the function Q [z] is the upper probability at a given point z of the standard normal distribution (mean 0, variance 1) (the same applies to the following formula (7)). $e_\alpha$ is the standard error of the regression coefficient $\alpha$ calculated in step S4 above.

$$Vn = 2e_\alpha \times Q\left[\frac{|Xa-Xn|}{\sigma x}\right] \quad \cdots (6)$$

According to the above formula (6), the variance Vn is maximal when Xn has the mean value Xa, and the value of the variance Vn decreases with an increase in the difference between Xa and Xn.

Fig. 6 shows a distribution curve of the measured values Y corresponding to a given measured value Xn based on a graph similar to that in Fig. 5, and also shows the range of this distribution curve in separate ranges, namely, the range $W_{ok}$ that is determined to be non-defective and the range $W_{NG}$ that is determined to be defective by the determination standard value Ys in the final inspection. As shown in Fig. 6, of the distribution of the measured values Y, the probability density of the range $W_{OK}$, which is greater than the determination standard value Ys, is used as the probability that the fillet formed when the cream solder volume is Xn is determined to be non-defective (non-defectiveness probability). The probability density of the range $W_{NG}$, which is smaller than or equal to the determination standard value Ys, is used as the probability that the fillet formed when the cream solder volume is Xn is determined to be defective (defectiveness probability).

Accordingly, in step S8, the non-defectiveness probability OKQn of the height Y of the fillet formed when the cream solder volume is Xn is determined by using the following formula (7), and the defectiveness probability NGQn of that fillet is further calculated by using the formula (8).

$$OKQn = Q\left[\frac{|Yn-Ys|}{\sqrt{Vn}}\right] \quad \cdots (7)$$

$$NGQn = 1-OKQn \quad \cdots (8)$$

Referring back to Fig. 4, the processes executed in and after step S10 will be described. After the loop of steps S6 to S9 is executed for all calculation target points and the non-defectiveness probability OKQn and the defectiveness probability NGQn of the measured values Y for the calculation target points are calculated, in step S10, for M calculation target points included in the range smaller than or equal to Xs (the range of the measured values for which the result in the intermediate inspection is determined to be defective), the mean values of the non-defectiveness probabilities OKQn and the defectiveness probabilities NGQn calculated for these points are calculated. The mean value of the non-defectiveness probabilities OKQn corresponds to the probability P1 of the group G1 and the mean value of the defectiveness probabilities NGQn corresponds to the probability P3 of the group G3.

Further, in step S11, also for (N-M) calculation target points included in the range greater than Xs (the range of measured values for which the result in the intermediate inspection is determined to be non-defective), the mean values of the non-defectiveness probabilities OKQn and the defectiveness probabilities NGQn calculated for the points are calculated in the same manner. The mean value of the non-defectiveness probabilities OKQn corresponds to the probability P2 of the group G2, and the mean value of the defectiveness probabilities NGQn corresponds to the probability P4 of the group G4.

Thereafter, the degree of separation S is calculated by executing the formula (1) above using the probabilities P1, P2, P3, and P4 (step S12), and the suitability of the determination standard value Xs is determined by comparing the calculated values with the threshold that has been registered in advance (step S13).

Finally, the result of the above-described determination is output by a method, including, for example, the display to a monitor (step S14), and the process ends.

With the above-described process, even if a sufficient number of samples indicating the values corresponding to a defect has not been obtained, when a considerable number of samples are used to accurately determine the distribution patterns of the measured values X and Y and the correlation between the two patterns, the probability distribution of the measured values Y for each calculation target point of the measured values X can be accurately specified from the these samples, thus determining the non-defectiveness probability and the defectiveness probability. Accordingly, even for a group for which a sufficient number of samples have not been obtained, the occurrence probability can be accurately determined and the precision of the degree of separation S can also be ensured, and therefore it is possible to ensure the accuracy of determination of the suitability of the determination standard value Xs.

Although in the process shown in Fig. 4, the non-defectiveness probability and the defectiveness probability are calculated in steps S6 to S9 for each calculation target point and the mean value of probability is calculated in steps S10 and S11 for each range divided by the determination standard value Xs and for each probability type, the present invention is not limited thereto and only one of the non-defectiveness probability and the defectiveness probability may be calculated for each calculation target point and only the mean value of the calculated probabilities may be determined. For example, if only the non-defectiveness probability is calculated, then the probability P1 is calculated in step S10 and the probability P2 is calculated in step S11. On the other hand, if only the defectiveness probability is calculated, the probability P3 is calculated in step S10 and the probability P4 is calculated in step S11. Thus, in either case, it is possible to determine the degree of consistency and the degree of inconsistency between the results of the inspections.

Next, the process that is executed if the determination standard value Xs for the measured values X is determined to be unsuitable by the process shown in Fig. 4 will be described. This process may be executed, for example, in response to the operation to instruct a correction of the current determination standard value Xs performed by the user that has confirmed a determination result for the determination standard value Xs.

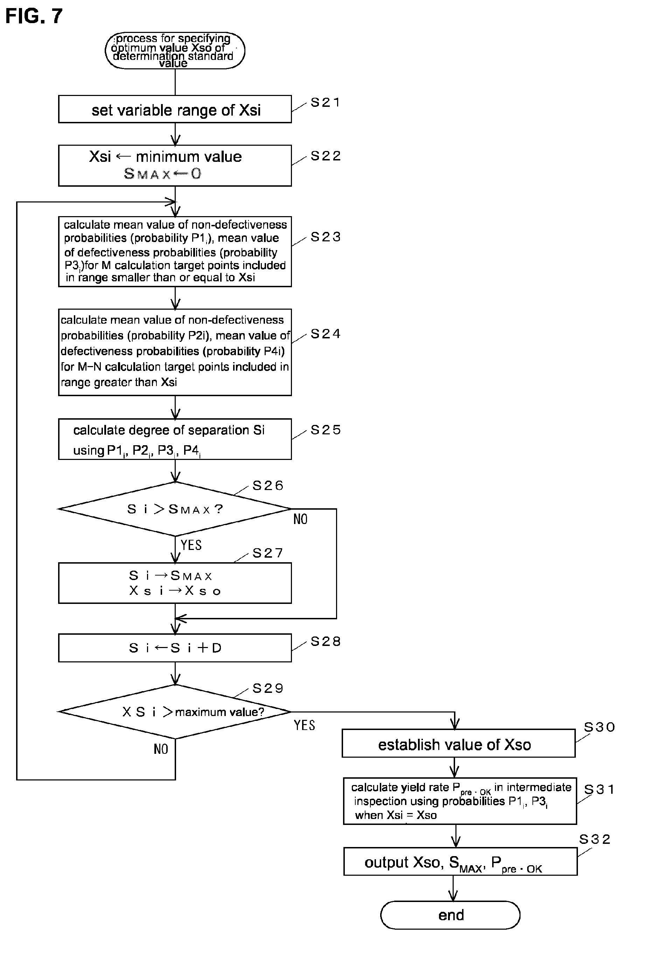

Fig. 7 shows the procedure of the process for specifying an optimum value of the determination standard value Xs.

In this process, the optimum value Xso of the determination standard value Xs is specified using the non-defectiveness probability and the defectiveness probability that have been determined in steps S6 to S9 in Fig. 4 for each calculation target point.

First, in the first step S21, Xsi is taken as a temporary value of the determination standard value Xs and the variation range of Xsi is set. For example, the range in which calculation target points have been set by the process in Fig. 4 can be set as the variation range. The range from the minimum value to the maximum value of the measured values X indicated by actual samples may be set as the variation range. Alternatively, with the use of the current determination standard value Xs and a fixed value DX, the range from Xs - DX to Xs + DX may be set as the variation range.

Next, the minimum value of the above-described variation range is set to Xsi and the maximum value $S_{MAX}$ of the degree of separation S is set to the initial value 0 (step S22). Then, in steps S23 and S24, the occurrence probabilities $P1_i$, $P2_i$, $P3_i$, and $P4_i$ of the four groups $G1_i$, $G2_i$, $G3_i$, $G4_i$ classified by Xsi and Ys are calculated, and the degree of separation Si is calculated using the probabilities P1 to P4 (step S25). Note that the calculations performed in steps S23, S24, and S25 are the same as steps S10, S11, and S12 in Fig. 4, and therefore the detailed description thereof is omitted.

Further, the degree of separation Si is compared with the maximum value $S_{MAX}$ (step S26), and, if Si > $S_{MAX}$, the maximum value $S_{MAX}$ is rewritten with the value of Si (step S27). Also, the value of Xsi at this time is stored in the variable Xso.

Thereafter, while increasing the value of Xsi by increments of the fixed value D until Xsi exceeds the maximum value of the variation range (steps S28, S29), steps S23 to S26 are executed for Xsi each time, and, if the degree of separation Si exceeds the maximum value $S_{MAX}$, step S27 is further executed. Then, the value of Xso at the end of the loop of steps S23 to S29 is established as the optimum value of the determination standard value Xs (step S30).

In step S31, the yield rate $P_{pre \cdot OK}$ (the probability that no defect is detected from the substrate to be inspected) in the intermediate inspection is calculated using the above-described probabilities $P1_i$ and $P2_i$ when Xso is set to Xsi that have been calculated in step S23. Specifically, only the portions on the substrate for which the determination standard value Xs is set are focused on, and the following formula (9) is executed assuming that no defect occurs in the other portions.

$$P_{pre \cdot OK} = (1 - (P1_i + P3_i))^{SUM} \quad \cdots \quad (9)$$

(SUM is the total number of the portions of interest on the substrate)

Thereafter, in step S32, the values of the optimum value Xso of the determination standard value Xs, the degree of separation $S_{MAX}$, and the yield rate $P_{pre \cdot OK}$ are output, and the process ends.

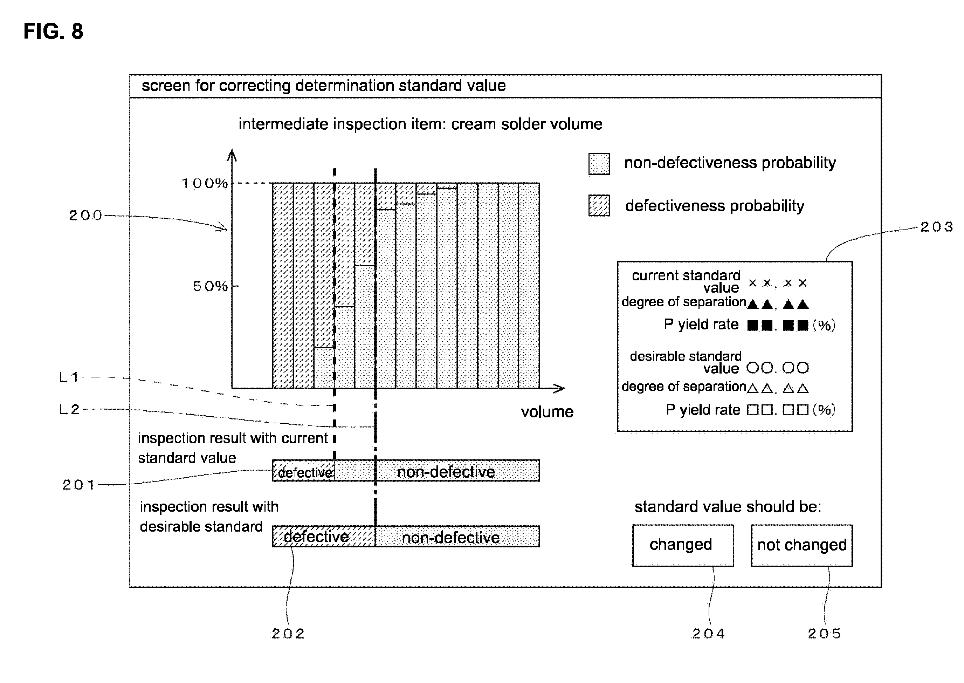

Fig. 8 shows a display screen as an example of output of the optimum value Xso and the degree of separation $S_{MAX}$ specified by the above-described process and the yield rate $P_{pre \cdot OK}$. This screen shows a bar chart 200 on which the measured values of the inspection item (cream solder volume) for which the determination standard value is to be corrected are divided into ranges by a fixed width and the non-defectiveness probability and the defectiveness probability of the fillet formed from the cream solder having a volume included in each of the ranges are color-coded.

The bar chart 200 can be created based on the results of the calculations performed in step S6 to S9 in Fig. 4. Although not shown in Fig. 8, the numbers representing specific measured values are shown at the positions on the horizontal axis of the bar chart 200 that correspond to the bars.

Further, the line L1 indicating the current determination standard value Xs for the cream solder volume and the line L2 indicating the optimum value Xso specified by the process shown in Fig. 7 are set on the bar chart 200. Below the bar chart 200, a chart 201 indicating the range that is determined to be defective and the range that is determined to be non-defective when an inspection is performed with the current determination standard value Xs and a chart 202 indicating the range that is determined to be defective and the range that is determined to be non-defective when an inspection is made with the optimum value Xso are displayed in correspondence with the horizontal axis representing the cream solder volume. On the right side of the chart 200, a display field 203 that displays actual numeric values indicated by the lines L1 and L2 and the corresponding values of the degree of separation and the yield rate is provided.

Further, operation buttons 204 and 205 for determining whether to change the determination standard value Xs are provided on the lower left of the screen. The user examines whether to change the current determination standard value Xs to the optimum value Xso based on, for example, the relationship between the charts 200, 201, and 202 and the lines L1 and L2, the numeric values displayed in the display field 203, and the user clicks the button 204 if the user decides to make a change. By this clicking operation, the determination standard value Xs stored in the inspection program management device 101 is rewritten with the optimum value Xso indicated by the line L2. Furthermore, the inspection program management device 101 transmits the updated determination standard value Xs to the solder print inspection machine 10, and the solder print inspection machine 10 that has received the updated value also executes the process for rewriting the determination standard value.

On the other hand, if the button 205 is clicked, the determination standard value Xs will not be changed and is maintained as the current value.

With the above-described display, the relationship between the value of the cream solder volume and the proportion of the non-defectiveness probability and the defectiveness probability in the final inspection and the difference between the determination result obtained with the current determination standard value Xs and the determination result obtained with the optimum value Xso are clearly shown, and therefore the user who has viewed the display can easily determine whether to change the determination standard value Xs. If the user places importance on the productivity, the value of the yield rate in the field 203 can be used as an indicator of judgment.

However, the user judgment is not necessarily required, and, after the optimum value Xso for the determination standard value is specified by the process shown in Fig. 7, the determination standard value Xs may be automatically rewritten with the optimum value Xso.

In the above-described embodiment, the suitability of the current determination standard value is determined and the optimum value for the determination standard value is specified if the value is determined to be unsuitable. However, the optimum value for the determination standard value may be determined by consecutively executing steps S1 to S9 in Fig. 4 and the steps in Fig. 7, without determining the suitability of the current value, and thereafter the determination standard value may be automatically corrected with that optimum value. The process to be performed in this case may be presented to the user as a process for optimizing the determination standard value Xs used for the intermediate inspection, and this optimization process may be executed as needed upon reception of an execution instruction from the user.

Even in a stage at which the determination standard value Xs has not been set and before the start of intermediate inspection, if there is a certain number of samples of the actual measured values for the measured values X and Y or if the measured values are obtained through simulation, the determination standard value Xs for an intermediate step may be determined by steps S1 to S9 in Fig. 4 and the steps in Fig. 7. In this case as well, by executing the optimization process as needed in response to accumulation of the measured values in a subsequent inspection, it is possible to change the determination standard value Xs to the optimum value.

Although the cream solder volume is inspected in the intermediate inspection and the fillet height is inspected in the final inspection in the above-described embodiment, the combination of inspection items is not limited thereto. Note that among various inspection items of the intermediate inspection, items for which the suitability determination and the correction of the determination standard value can be made are to be checked with inspection items of the final inspection that are used for such a process by the above-described method, the correlation coefficient γ may be calculated for a given combination of the inspection items of the intermediate inspection and the inspection items of the final inspection by using the formula (2), and whether the correlation coefficient γ exceeds a predetermined standard value may be checked.

Although the suitability of the determination standard value Xs is determined by the indicator, namely, the degree of separation S in the above-described embodiment, the indicator for the determination is not limited thereto. For example, the ratio of the degree of inconsistency between the intermediate inspection result and the final inspection result (P1 + P3) to the degree of consistency between the inspection results (P2 + P4) may be used. Alternatively, the yield rate $P_{pre \cdot OK}$ in the intermediate inspection may be used as the determination indicator.

The processes shown in Figs. 4 and 7 are not limited to substrates on which components are mounted. For any product that is produced through a plurality of steps and for which there is a correlation between the measured values subjected to the intermediate inspection and the measured values subjected to the final inspection, it is possible to determine the suitability of the determination standard value for the intermediate inspection and specify the optimum value of the determination standard value by a similar method.

Next, at a production site with a policy that if any defect is detected by the inspection in a step before the reflow step, the substrate for which the defect has been detected is removed from the production line (no subsequent step is performed), it is necessary to perform the intermediate inspection as accurately as possible. With regard to this problem, an example of a simulation process will be described below in which in response to a user input of the determination standard value used for the intermediate inspection, the indicator indicating the production efficiency is calculated from the input value.

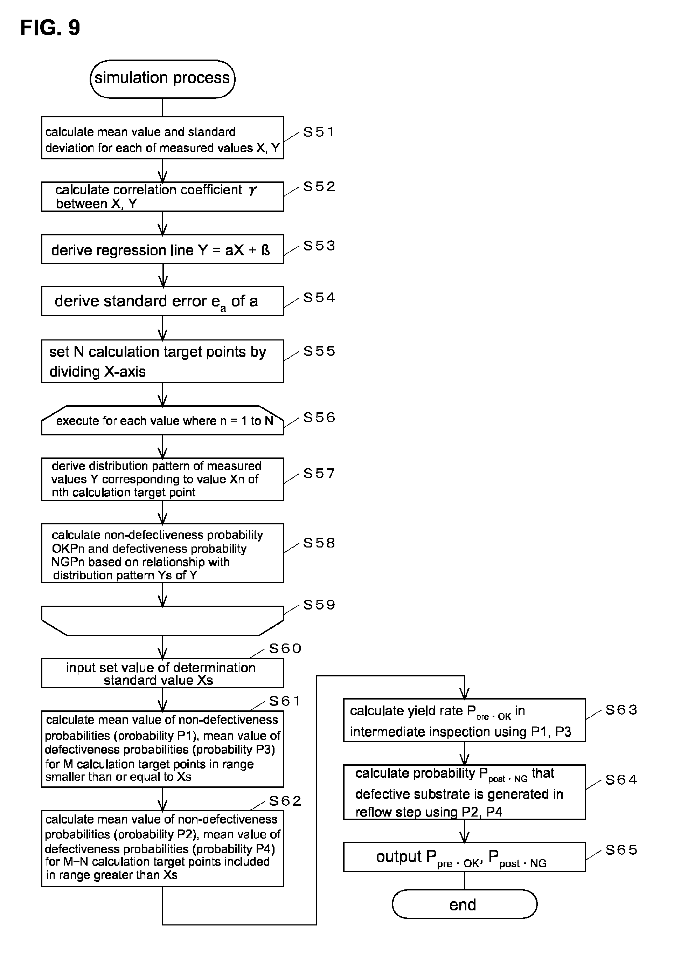

Fig. 9 shows the procedure of a process relating to the above-described simulation. The process of this example is executed by the inspection program management device 101 and a terminal device (not shown) connected thereto that work cooperatively.

The process shown in Fig. 9 is also executed, assuming that a plurality of samples of combinations of the measured values X and Y obtained by the intermediate inspection and the final inspection are provided for each component of a specific component type. To simplify the illustration, in this example, a plurality of components to which a common specific determination standard is applied are mounted to a substrate, and the simulation is performed assuming that if no defect occurs in these components, then the substrate as a whole will be a non-defective product. Also, the simulation is performed assuming that the simulation is performed for the cream solder volume inspected in the intermediate inspection and the fillet height inspection inspected in the final inspection, and no defect occurs in other inspections.

In this embodiment as well, the process is started assuming that a plurality of samples of combinations of the measured values X and Y are accumulated in the inspection program management device 101. The process from S51 to S59 in Fig. 9 corresponds to steps S1 to S9 in Fig. 4. That is, a correlation between the measured values X and Y is derived, N calculation target points are set on the X-axis, and, for each calculation target point, the non-defectiveness probability OKPn and the defectiveness probability NGPn of the fillet formed by the cream solder corresponding to the measured value Xn indicated by that point are calculated.

Next, an input of the set value of the determination standard value Xs used for the intermediate inspection is accepted (step S60), and the calculations similar to those in steps S10 and S11 in Fig. 4 are performed using the Xs (steps S61, S62). Consequently, the occurrence probabilities P1, P2, P3, and P4 of the four groups G1, G2, G3, and G4 classified by Xs and Ys are calculated (see Fig. 3).

Of the above-described probabilities, the sum of P1 and P3 corresponds to the probability that a single portion to be inspected is determined to be defective in the intermediate inspection. P2 corresponds to the probability that the fillet formed from the cream solder at a portion that has passed the intermediate inspection is determined to be non-defective in the final inspection, and P4 corresponds to the probability that the fillet formed from the cream solder at a portion that has passed the intermediate inspection is determined to be defective in the final inspection.

In step S63, the yield rate $P_{pre \cdot OK}$ in the intermediate inspection is calculated by performing the same calculation as the above formula (9) using the probabilities P1 and P3. Further, in step S64, assuming that any substrate for which a defect has been detected in the intermediate inspection (any substrate that has failed the intermediate inspection) is removed from the production line, the probability $P_{post \cdot NG}$ that a defective substrate is generated in the final step is calculated by performing the following formula (10) using the probabilities P2 and P4.

$$P_{post \cdot NG} = (P4 \times (P2 + P4)) \, SUM \quad \cdots \quad (10)$$

Further, in step S65, the yield rate $P_{pre \cdot OK}$ and the occurrence probability $P_{post \cdot NG}$ of the defective substrate are displayed to a monitor. Note that although not shown in Fig. 9, if a numeric value different from Xs is subsequently input, the process is executed from step S61, using the previous process results of steps S51 to S59 and the newly input Xs.

In order to increase the reliability of the above-described simulation, components on the substrate may be divided into groups to each of which the same inspection standard is applied, steps S51 to S64 described above may be executed for each group, then the product of the yield rates and the product of the occurrence rate of defective substrates may be determined for each group and these may be displayed as the final results. In the foregoing, the yield rate and the occurrence rate of defective substrates are determined for the intermediate inspection and the final inspection, respectively, the relationship between the calculated parameters may be inversed. Alternatively, the yield rate may be determined for both of the intermediate inspection and the final inspection.

With the above-described simulation, if an intermediate inspection is performed with a value that the user has input as the determination standard value Xs for the inspection, the user is able to know an approximate proportion of substrates that will pass the intermediate inspection and be sent to the reflow step and an approximate proportion of defective substrates that are generated eventually. Then, it is possible to judge that the determination standard value Xs is suitable if these numeric values match the production target.

INDEX TO THE REFERENCE NUMERALS

| 10, 20 | inspection machine for intermediate inspection |
| --- | --- |
| 30 | inspection machine for final inspection |
| 101 | inspection program management device |
| 102 | inspection data management device |
| X | measured value in intermediate inspection |
| Y | measured value in final inspection |
| Xs | determination standard value used for intermediate inspection |
| Ys | determination standard value used for final inspection |

**Claims**

1. A suitability determination method for a determination standard value, for determining, based on a relationship between a final inspection of inspecting a final-form product formed through a plurality of steps and an intermediate inspection of inspecting an intermediate product formed in a step before the final step, whether a determination standard value used for the intermediate inspection is suitable, the method comprising:

   a first step of executing, for each of a plurality of intermediate products and final-form products formed from the intermediate products, a measurement process for obtaining a characteristic amount to be inspected, and setting a plurality of samples by forming combinations of the measured values, each of the combinations corresponding to the same product;
   a second step of deriving a correlation between the measured values for the intermediate products and the measured values for the final-form products by using the combinations of the measured values indicated by the plurality of samples;
   a third step of executing a first calculation process for setting a plurality of calculation target points in a range in which the measured values for the intermediate products can be distributed and specifying a distribution pattern of the measured values of the final-form products that corresponds to the measured values indicated by the calculation target points based on the correlation derived in the second step, and a second calculation process for determining, based on the relationship between the distribution pattern and the determination standard value used for the final inspection, at least one of a probability that the final-form products formed from the intermediate products for which the measured values indicated by the calculation target points are obtained are determined to be non-defective in the final inspection and a probability that said final-form products are determined to be defective in the final inspection, the third step being executed for each of the calculation target points;
   a fourth step of dividing the range in which the calculation target points are set into a range that is determined to be non-defective and a range that is determined to be defective based on the determination standard value used for the intermediate inspection, and determining, for each of said ranges, the degree of consistency between a result of the intermediate inspection and a result of the final inspection and the degree of inconsistency between said inspection results by using the probability calculated by the second calculation process for the calculation target points included in the range; and
   a fifth step of determining whether the determination standard value used for the intermediate inspection is suitable based on the degree of consistency and the degree of inconsistency in each of the ranges that have been determined in the fourth step.

2. The suitability determination method for a determination standard value according to claim 1,
   wherein in the second step, a regression line between the measured values for the intermediate products and the measured values for the final-form products is derived, and,

in the first calculation process of the third step, a mean value of the measured values of the final-form products is determined by applying the measured values corresponding to the calculation target points to the formula of the regression line, and a variation in the measured values of the final-form products is calculated by correcting the standard error of the regression line using a correction function that functions to decrease the value of the standard error with an increase in the difference between a mean value of the measured values for the intermediate products that are indicated by the plurality of samples and the measured values indicated by the calculation target points.

3. The suitability determination method for a determination standard value according to claim 1,

wherein in the fourth step, for each of the divided ranges, a mean value of the probabilities that have been calculated by the second calculation process for the calculation target points included in the range is calculated, and, based on a result of the calculation, for each combination of a result of the intermediate inspection and a result of the final inspection, the occurrence probability of that combination is calculated.

4. A method for specifying an optimum value of a determination value, for deriving, based on a relationship between a final inspection of inspecting a final-form product formed through a plurality of steps and an intermediate inspection of inspecting an intermediate product formed in a step before the final step, an optimum value for a determination standard value used for an intermediate inspection:

a first step of executing, for each of a plurality of intermediate products and final-form products formed from the intermediate products, a measurement process for obtaining a characteristic amount to be inspected, and setting a plurality of samples by forming combinations of the measured values, each of the combinations corresponding to the same product;

a second step of deriving a correlation between the measured values for the intermediate products and the measured values for the final-form products by using the combinations of the measured values indicated by the plurality of samples;

a third step of executing a first calculation process for setting a plurality of calculation target points in a range in which the measured values for the intermediate products can be distributed and specifying a distribution pattern of the measured values of the final-form products that corresponds to the measured values indicated by the calculation target points based on the correlation derived in the second step, and a second calculation process for determining, based on the relationship between the distribution pattern and the determination standard value used for the final inspection, at least one of a probability that the final-form products formed from the intermediate products for which the measured values indicated by the calculation target points are obtained are determined to be non-defective in the final inspection and a probability that said final-form products are determined to be defective in the final inspection, the third step being executed for each of the calculation target points;

a fourth step of executing a process for dividing, while varying the determination standard value used for the intermediate inspection, the range in which the calculation target points are set into a range that is determined to be non-defective and a range that is determined to be defective based on the determination standard value, and determining, for each of said ranges, the degree of consistency between a result of the intermediate inspection and a result of the final inspection and the degree of inconsistency between said inspection results by using the probability calculated by the second calculation process for the calculation target points included in the range; the process being executed for each of the varied determination standard values; and

a fifth step of selecting, in response to determining the degree of consistency and the degree of inconsistency for each of the determination standard values in the fourth step, a suitable value from the determination standard values based on said degrees.

5. An inspection system for a substrate on which components are mounted, comprising an inspection machine for final inspection that is provided in a reflow step included in a plurality of steps for producing a substrate on which components are mounted, and an inspection machine for intermediate inspection that is provided in at least one step located before the reflow step, the system further comprising:

a computer system comprising: a storage means that stores results of a measurement process performed by the inspection machines and inspection results in a state in which the identity of a portion to be inspected can be specified; and a determination standard value processing means that analyses information stored in the storage means for a plurality of portions to be inspected to which the same determination standard value can be applied and executes a process relating to the determination standard value used for the intermediate inspection of the portions to be inspected,

wherein the determination standard value processing means comprises:

a sample setting means that sets a plurality of samples by forming combinations of the measured values in the intermediate inspection and the measured values in the final inspection of the plurality of portions to be inspected, each of the combinations corresponding to the same portion;

a correlation derivation means that derives a correlation between the measured values in the intermediate inspection and the measured values in the final inspection by using the combinations of the measured values indicated by the plurality of samples;

a first analysis means that executes a first calculation process for setting a plurality of calculation target points in a range in which the measured values in the intermediate inspection can be distributed and specifying a distribution pattern of the measured values in the final inspection that corresponds to the measured values indicated by the calculation target points based on the correlation derived by the correlation derivation means, and a second calculation process for determining, based on the relationship between the distribution pattern and the determination standard value used for the final inspection, at least one of a probability that the portions to be inspected for which the measured values indicated by the calculation target points are obtained are determined to be non-defective in the final inspection and a probability that said portions to be inspected are determined to be defective in the final inspection, the third step being executed for each of the calculation target points;

a second analysis means that divides the range in which the calculation target points are set into a range that is determined to be non-defective and a range that is determined to be defective based on the determination standard value used for the intermediate inspection, and determining, for each of said ranges, the degree of consistency between a result of the intermediate inspection and a result of the final inspection and the degree of inconsistency between said inspection results by using the probability calculated by the second calculation process for the calculation target points included in the range;

a determination means that determines whether the determination standard value used for the intermediate inspection is suitable based on the degree of consistency and the degree of inconsistency in each of the ranges that have been determined by the second analysis means; and

an output means that outputs a result of determination performed by the determination means.

6. An inspection system for a substrate on which components are mounted, comprising an inspection machine for final inspection that is provided in a reflow step included in a plurality of steps for producing a substrate on which components are mounted, and an inspection machine for intermediate inspection that is provided in at least one step located before the reflow step, the system further comprising:

a computer system comprising: a storage means that stores results of a measurement process performed by the inspection machines and inspection results in a state in which the identity of a portion to be inspected can be specified; and a determination standard value processing means that analyses information stored in the storage means for a plurality of portions to be inspected to which the same determination standard value can be applied and executes a process relating to the determination standard value used for the intermediate inspection of the portions to be inspected,

wherein the determination standard value processing means comprises:

a sample setting means that sets a plurality of samples by forming combinations of the measured values in the intermediate inspection and the measured values in the final inspection of the portions to be inspected, each of the combinations corresponding to the same portion;

a correlation derivation means that derives a correlation between the measured values in the intermediate inspection and the measured values in the final inspection by using the combinations of the measured values indicated by the plurality of samples;

a first analysis means that executes a first calculation process for setting a plurality of calculation target points in a range in which the measured values in the intermediate inspection can be distributed and specifying a distribution pattern of the measured values in the final inspection that corresponds to the measured values indicated by the calculation target points based on the correlation derived by the correlation derivation means, and a second calculation process for determining, based on the relationship between the distribution pattern and the determination standard value used for the final inspection, at least one of a probability that the portions to be inspected for which the measured values indicated by the calculation target points are obtained are determined to be non-defective in the final inspection and a probability that said portions to be inspected are determined to be defective in the final inspection, the third step being executed for each of the calculation target points;
a second analysis means that executes a process for dividing, while varying the determination standard value used for the intermediate inspection, the range in which the calculation target points are set into a range that is determined to be non-defective and a range that is determined to be defective based on the determination standard value, and determining, for each of said ranges, the degree of consistency between a result of the intermediate inspection and a result of the final inspection and the degree of inconsistency between said inspection results by using the probability calculated by the second calculation process for the calculation target points included in the range; the process being executed for each of the varied determination standard values; and
a determination standard value selection means that selects, in response to determining the degree of consistency and the degree of inconsistency for each of the determination standard values by the second analysis means, a suitable value from the determination standard values based on said degrees; and
an output means that output the determination standard value selected by the determination standard value selection means.

7. The inspection system for a substrate on which components are mounted according to claim 6,
wherein the output means is configured as a means that transmits, to the inspection machine for intermediate inspection, the determination standard value selected by the standard value selection means, and the inspection machine for intermediate inspection is provided with a means that registers the determination standard value transmitted from the output means for intermediate inspection.

8. A simulation method at a production site, for performing, using a computer, a simulation calculation for deriving, in a production line in which a final inspection of inspecting a final-form product formed through a plurality of steps and an intermediate inspection of inspecting an intermediate product formed in a step before the final step are performed, a result for each of the inspections, the method causing the computer to execute:

a first step of setting a plurality of samples by forming combinations of measured values, each of the measured values obtained by executing, for each of a plurality of intermediate products and final-form products formed from the intermediate products, a measurement process for obtaining a characteristic amount to be inspected, and each of the combinations corresponding to the same product;
a second step of deriving a correlation between the measured values for the intermediate products and the measured values for the final-form products by using the combinations of the measured values indicated by the plurality of samples;
a third step of executing a first calculation process for setting a plurality of calculation target points in a range in which the measured values for the intermediate products can be distributed and specifying a distribution pattern of the measured values of the final-form products that corresponds to the measured values indicated by the calculation target points based on the correlation derived in the second step, and a second calculation process for determining, based on the relationship between the distribution pattern and the determination standard value used for the final inspection, a probability that the final-form products formed from the intermediate products for which the measured values indicated by the calculation target points are obtained are determined to be non-defective in the final inspection and a probability that said final-form products are determined to be defective in the final inspection, the third step being executed for each of the calculation target points;
a fourth step of accepting an input of a set value as the determination standard value used for the intermediate inspection, dividing the range in which the calculation target points are set into a range that is determined to be non-defective and a range that is determined to be defective based on the input value, and determining a probability that the intermediate products are determined to be defective by using the two probabilities calculated by the second calculation process for the calculation target points included in the range that is determined to be defective, while determining a probability that a final product formed from an intermediate product that has passed the intermediate inspection is determined to be non-defective and a probability that said final product is determined to be defective by processing each of the two probabilities calculated by the second calculation process for the calculation target points included in the range that is determined to be non-defective;
a fifth step of determining, using the probabilities calculated in the fourth step, the proportion of intermediate products that pass or fail the intermediate inspection in a predetermined number of intermediate products produced in a production line and the proportion of intermediate products that pass or fail the final inspection in intermediate products that have passed the intermediate inspection; and
a sixth step of displaying the proportions calculated in the fifth step as results of the simulation calculation.

9. A computer simulation system for a production line for a substrate on which components are mounted, for executing, for a substrate production line comprising a plurality of steps for producing a substrate on which components are mounted and in which an inspection machine for intermediate inspection is provided in a reflow step included in said steps and inspection machine for final inspection is provided in at least one step located before the reflow step, a simulation calculation for deriving results of the inspections performed in the production line and displaying the results, the system comprising:

a storage means that stores measured values obtained by a measurement process executed by the inspection machines for obtaining a characteristic amount to be inspected in a state in which the identity of a portion to be inspected can be specified and stores the determination standard value used for the final inspection; an input means that accepts an input of a set value of the determination standard value used for the intermediate inspection of a plurality of portions to be inspected to which the same determination standard value can be applied; a simulation calculation means that analyses information stored in the storage means for the portions to be inspected to which the input determination standard value is applied and executes a simulation calculation for the portions to be inspected; and a display means that displays results of the simulation calculation,

wherein the simulation calculation means comprises:

a sample setting means that sets a plurality of samples by forming combinations of the measured values obtained from by the inspection machines for the portions to be inspected that are subject to calculation, each of the combinations corresponding to the same portion;

a correlation derivation means that derives a correlation between the measured values in the intermediate inspection and the measured values in the final inspection by using the combinations of the measured values indicated by the plurality of samples;

a first analysis means that executes a first calculation process for setting a plurality of calculation target points in a range in which the measured values obtained by the measurement process for the intermediate inspection can be distributed and specifying a distribution pattern of the measured values in the final inspection that corresponds to the measured values indicated by the calculation target points based on the correlation derived by the correlation derivation means, and a second calculation process for determining, based on the relationship between the distribution pattern and the determination standard value for the final inspection that is stored in the storage means, a probability that the portions to be inspected for which the measured values indicated by the calculation target points are obtained are determined to be non-defective in the final inspection and a probability that said portions to be inspected are determined to be defective in the final inspection, the third step being executed for each of the calculation target points;

a second analysis means divides the range in which the calculation target points are set into a range that is determined to be non-defective and a range that is determined to be defective based on the set value of the determination standard value accepted by the input means, and determines a probability that the portions to be inspected are determined to be defective in the intermediate inspection of the calculation target points included in the range that is determined to be defective by using the two probabilities calculated by the second calculation process, while determining a probability that portions that have passed the intermediate inspection are determined to be non-defective in the final inspection and a probability that said portions are determined to be defective in the final inspection by processing each of the two probabilities calculated in the second calculation process for the calculation target points included in the range that is to be non-defective; and

a third analysis means that determines, using the probabilities calculated by the second analysis means, the proportion of substrates that pass or fail the intermediate inspection in substrates introduced into a step in which the inspection machine for intermediate inspection is provided and the proportion of substrates that pass or fail the final inspection in substrates that have passed the intermediate inspection, and

the display means displays the proportions calculated by the third analysis means as results of the simulation calculation.

**FIG. 1**

solder print step    component mount step    reflow step

| solder print device (11) | solder print inspection machine (10) | mounter (21) | component inspection machine (20) | reflow furnace (31) | soldering inspection machine (30) |

flow of substrates

inspection program management device (101)

inspection data management device (102)

100

## FIG. 2

measured data of inspection          measured data of inspection
of cream solder volume               of fillet height

Samp2

Samp1          k1 (wetting defect)   k2 (lead bending)

## FIG. 3

(fillet height)

Y

non-defective          G1 | G2

Ys - - - - - - - - - - - - - - - - - - - -

defective          G3 | G4

→ X (cream solder volume)

defective | non-defective

X's

# FIG. 4

```
        ┌─────────────────────────┐
        │ process for determining │
        │ suitability of determination │
        │    standard value       │
        └─────────────────────────┘
                    │
                    ▼
  ┌──────────────────────────────────┐
  │ calculate mean value and standard │  S1
  │ deviation for each of measured values X, Y │
  └──────────────────────────────────┘
                    │
                    ▼
  ┌──────────────────────────────────┐
  │ calculate correlation coefficient γ │  S2
  │ between X, Y                       │
  └──────────────────────────────────┘
                    │
                    ▼
  ┌──────────────────────────────────┐
  │ derive regression line Y = aX + ß │  S3
  └──────────────────────────────────┘
                    │
                    ▼
  ┌──────────────────────────────────┐
  │ derive standard error $e_a$ of a  │  S4
  └──────────────────────────────────┘
                    │
                    ▼
  ┌──────────────────────────────────┐
  │ set N calculation target points   │  S5
  │ by dividing X-axis                │
  └──────────────────────────────────┘
                    │
                    ▼
  ┌──────────────────────────────────┐
  │ execute for each value where      │  S6
  │ n = 1 to N                        │
  └──────────────────────────────────┘
                    │
                    ▼
  ┌──────────────────────────────────┐
  │ derive distribution pattern of measured │  S7
  │ values Y corresponding to value Xn of │
  │ nth calculation target point      │
  └──────────────────────────────────┘
                    │
                    ▼
  ┌──────────────────────────────────┐
  │ calculate non-defectiveness probability │  S8
  │ OKPn and defectiveness probability │
  │ NGPn based on relationship with   │
  │ distribution pattern Ys of Y      │
  └──────────────────────────────────┘
                    │
                    ▼
  ┌──────────────────────────────────┐  S9
  └──────────────────────────────────┘
                    │
                    ▼
  ┌──────────────────────────────────┐
  │ calculate mean value of non-defectiveness │  S10
  │ probabilities (probability P1), mean value of │
  │ defectiveness probabilities (probability P3) │
  │ for M calculation target points in range │
  │ smaller than or equal to Xs       │
  └──────────────────────────────────┘
                    │                                       S11
                    ▼
  ┌──────────────────────────────────┐
  │ calculate mean value of non-defectiveness │
  │ probabilities (probability P2), mean value of │
  │ defectiveness probabilities (probability P4) │
  │ for M−N calculation target points included in │
  │ range greater than Xs             │
  └──────────────────────────────────┘
```

┌──────────────────────────────────┐
│ calculate degree of separation S  │  S12
│ using P1, P2, P3, P4              │
└──────────────────────────────────┘
                    │
                    ▼
┌──────────────────────────────────┐
│ determine suitability of determination │  S13
│ standard value Xs by comparing degree of │
│ separation S with threshold       │
└──────────────────────────────────┘
                    │
                    ▼
┌──────────────────────────────────┐
│ output determination result       │  S14
└──────────────────────────────────┘
                    │
                    ▼
              ┌──────────┐
              │   end    │
              └──────────┘

**FIG. 5**

(fillet height)

$Y$

$Y = \alpha X + \beta$

$Y_{an3}$

$Y_{an2}$

$Y_{an1}$

$X_{n1}$  $X_{n2}$  $X_{n3}$

$X$  (cream solder volume)

**FIG. 6**

(fillet height)

$Y$

$Y = \alpha X + \beta$

$W_{OK}$

$Y_s$

$W_{NG}$

$X$  (cream solder volume)

$X_n$

**FIG. 7**

# FIG. 8

screen for correcting determination standard value

intermediate inspection item: cream solder volume

□ non-defectiveness probability

▨ defectiveness probability

200

203

current standard value ×× . ××
degree of separation ▲▲ . ▲▲
P yield rate ■■ . ■■ (%)

desirable standard value ○○ . ○○
degree of separation △△ . △△
P yield rate □□ . □□ (%)

L1

L2

volume

inspection result with current standard value

defective    non-defective

201

inspection result with desirable standard

defective    non-defective

standard value should be:

changed      not changed

202

204        205

EP 2 477 469 A2

## FIG. 9

```
      ( simulation process )
               │
               ▼
┌────────────────────────────────┐  S51
│ calculate mean value and standard │
│ deviation for each of measured values X, Y │
└────────────────────────────────┘
               │
               ▼
┌────────────────────────────────┐  S52
│ calculate correlation coefficient γ │
│ between X, Y                     │
└────────────────────────────────┘
               │
               ▼
┌────────────────────────────────┐  S53
│ derive regression line Y = aX + ß │
└────────────────────────────────┘
               │
               ▼
┌────────────────────────────────┐  S54
│ derive standard error e_a of a   │
└────────────────────────────────┘
               │
               ▼
┌────────────────────────────────┐  S55
│ set N calculation target points by │
│ dividing X-axis                  │
└────────────────────────────────┘
               │
               ▼
\  execute for each value where n = 1 to N  /  S56
               │
               ▼
┌────────────────────────────────┐  S57
│ derive distribution pattern of measured │
│ values Y corresponding to value Xn of │
│ nth calculation target point     │
└────────────────────────────────┘
               │
               ▼
┌────────────────────────────────┐  S58
│ calculate non-defectiveness probability │
│ OKPn and defectiveness probability │
│ NGPn based on relationship with  │
│ distribution pattern Ys of Y     │
└────────────────────────────────┘
               │
               ▼
_____/  S59
               │
               ▼
┌────────────────────────────────┐  S60
│ input set value of determination │
│ standard value Xs                │
└────────────────────────────────┘
               │
               ▼
┌────────────────────────────────┐  S61
│ calculate mean value of non-defectiveness │
│ probabilities (probability P1), mean value of │
│ defectiveness probabilities (probability P3) │
│ for M calculation target points in range │
│ smaller than or equal to Xs      │
└────────────────────────────────┘
               │
               ▼
┌────────────────────────────────┐  S62
│ calculate mean value of non-defectiveness │
│ probabilities (probability P2), mean value of │
│ defectiveness probabilities (probability P4) │
│ for M−N calculation target points included │
│ in range greater than Xs         │
└────────────────────────────────┘
```

```
               ▼
┌────────────────────────────────┐  S63
│ calculate yield rate P_{pre · OK} in │
│ intermediate inspection using P1, P3 │
└────────────────────────────────┘
               │
               ▼
┌────────────────────────────────┐  S64
│ calculate probability P_{post · NG} that │
│ defective substrate is generated in │
│ reflow step using P2, P4         │
└────────────────────────────────┘
               │
               ▼
┌────────────────────────────────┐  S65
│ output P_{pre · OK}, P_{post · NG} │
└────────────────────────────────┘
               │
               ▼
          (   end   )
```

**EP 2 477 469 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3966336 B
- JP 4552749 B
- JP 2008010666 A